(19) Europäisches Patentamt
European Patent Office
Office européen des brevets

(11) **EP 2 811 536 A1**

(12) **EUROPEAN PATENT APPLICATION**
published in accordance with Art. 153(4) EPC

(43) Date of publication:
**10.12.2014 Bulletin 2014/50**

(51) Int Cl.:
**H01L 31/042** *(2014.01)* **H01L 31/04** *(2014.01)*

(21) Application number: **13744026.9**

(86) International application number:
**PCT/JP2013/052020**

(22) Date of filing: **30.01.2013**

(87) International publication number:
**WO 2013/115236 (08.08.2013 Gazette 2013/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.01.2012 JP 2012016819**
**30.01.2012 JP 2012016814**

(71) Applicant: **JX Nippon Oil & Energy Corporation Chiyoda-ku Tokyo 100-8162 (JP)**

(72) Inventors:
• **YOSHIDOMI Masanobu**
  **Nagoya-shi**
  **Aichi 465-0092 (JP)**
• **ISHII Takafumi**
  **Tokyo 100-8162 (JP)**

(74) Representative: **Grünecker, Kinkeldey, Stockmair & Schwanhäusser**
**Leopoldstrasse 4**
**80802 München (DE)**

(54) **SOLAR POWER GENERATION SYSTEM AND FAILURE DETECTION METHOD**

(57) A photovoltaic power generation system comprises a photovoltaic module having a photovoltaics for generating power by utilizing solar light, a bypass diode connected in parallel with the photovoltaics, and a detection unit for detecting an open-mode failure of the bypass diode. A, failure detection method comprises a detection step of detecting an open-mode failure of a bypass diode connected in parallel with a photovoltaics for generating power by utilizing solar light, the detection step detecting the open-mode failure of the bypass diode when a predetermined reverse voltage value is applied to the photovoltaics, the predetermined reverse voltage value being a voltage drop value greater than that of the photovoltaics occurring when a current having a maximum current value flows through the bypass diode.

*Fig.2*

100(90)

EP 2 811 536 A1

## Description

### Technical Field

The present invention relates to a photovoltaic power generation system and a failure detection method.

### Background Art

In photovoltaic modules which generate power by utilizing solar light in general, there are cases where reverse voltages are applied to photovoltaics under the influence of variations in their characteristics and fluctuations in solar radiation intensity, for example, and may increase to such an extent as to heat and eventually damage the photovoltaics. Therefore, some of the conventional photovoltaic modules have been known to connect a bypass diode in parallel with photovoltaics, so as to inhibit excessive reverse voltages from being applied to the photovoltaics (see, for example, Patent Literature 1).

### Citation List

### Patent Literature

Patent Literature 1: Japanese Patent Application Laid-Open No. 2001-024204

### Summary of Invention

### Technical Problem

Here, photovoltaic power generation systems equipped with photovoltaic modules are desired to detect open-mode failures of bypass diodes.

It is therefore an object of the present invention to provide a photovoltaic power generation system and failure detection method for detecting an open-mode failure of a bypass diode.

### Solution to Problem

The photovoltaic power generation system in accordance with one aspect of the present invention comprises a photovoltaic module having a photovoltaics for generating power by utilizing solar light, a bypass diode connected in parallel with the photovoltaics, and a detection unit for detecting an open-mode failure of the bypass diode.

The failure detection method in accordance with one aspect of the present invention comprises a detection step of detecting an open-mode failure of a bypass diode connected in parallel with a photovoltaics for generating power by utilizing solar light, the detection step detecting the open-mode failure of the bypass diode when a predetermined reverse voltage value is applied to the photovoltaics, the predetermined reverse voltage value being a voltage drop value greater than that of the photovoltaics occurring when a current having a maximum current value flows through the bypass diode.

### Advantageous Effects of Invention

One aspect of the present invention makes it possible to detect the open-mode failure of the bypass diode.

### Brief Description of Drawings

Fig. 1 is a structural diagram illustrating a photovoltaic power generation system including the failure detection device in accordance with a first embodiment;
Fig. 2 is a structural diagram illustrating a photovoltaic module of the photovoltaic power generation system of Fig. 1;
Fig. 3 is a set of graphs illustrating IV curve characteristics in a photovoltaic unit in the photovoltaic module of Fig. 1;
Fig. 4 is a set of diagrams for explaining a bypass diode;
Fig. 5 is a structural diagram illustrating a photovoltaic power generation system including the failure detection device in accordance with a second embodiment;
Fig. 6 is a structural diagram illustrating a photovoltaic module of a photovoltaic power generation system including the failure detection device in accordance with a third embodiment;

Fig. 7 is a structural diagram illustrating a photovoltaic module of a photovoltaic power generation system including the failure detection device in accordance with a fourth embodiment;

Fig. 8 is a structural diagram illustrating a photovoltaic module of a photovoltaic power generation system including the failure detection device in accordance with a fifth embodiment; and

Fig. 9 is a structural diagram illustrating a photovoltaic module of a photovoltaic power generation system including the failure detection device in accordance with a sixth embodiment.

**Description of Embodiments**

A technique may be developed such as to shield a photovoltaics from light with a shielding plate and detect the temperature of the shielded part in the photovoltaics by thermal paper integrated with the shielding plate, and when hot-spot heat (abnormal heating) generation is detected in the shielded part of the photovoltaics, it is decided that no current flows through the bypass diode, from which it is determined that the bypass diode is in an open-mode failure.

While it is necessary for the above-mentioned technique to shield the photovoltaics from light in order to detect the open-mode failure of the bypass diode as in the foregoing, the photovoltaics is typically installed at a high place such as a roof, which makes the operation cumbersome in practice and unsuitable for daily inspections in terms of safety and cost.

From the following reason, it may also become difficult for the above-mentioned technique to determine whether or not the bypass diode fails. That is, even when the bypass diode is not in the open-mode failure, there is a case where a reverse voltage is applied to some extent to the photovoltaics shielded from light, whereby the heating of the photovoltaics is detected. The extent of the heating depends on the solar radiation intensity at the time, the state of light shielding, the current density of the photovoltaics, the heat dissipation state of the photovoltaics, the shunt resistance component of the photovoltaics, and the like and cannot be expected unconditionally. This makes it very hard to distinguish between the heating in a normal range and that caused by failures of the bypass diode, whereby the open-mode failure of the bypass diode may not be detected accurately.

Furthermore, when the bypass diode is in the open-mode failure, prompt handling is needed in order to prevent the photovoltaics from heating and breaking. However, while being unable to detect the failure accurately and expected to delay the handling, the above-mentioned technique may determine that a normally functioning bypass diode is in a failure and handle it accordingly, thus unnecessarily lowering or suppressing the power generation capacity of the photovoltaics.

In view of the foregoing circumstances, it is an object of one aspect of the present invention to make it easy to improve reliability while securing a power generation capacity.

For achieving the above-mentioned object, a photovoltaic module included in the photovoltaics system in accordance with one aspect of the present invention comprises a photovoltaics for generating power by utilizing solar light, a bypass diode connected in parallel with the photovoltaics, a detection unit for detecting an open-mode failure of the bypass diode, and a blocking unit for blocking a current of the photovoltaics when the detection unit detects the open-mode failure of the bypass diode.

In this photovoltaic module, the bypass diode can keep high reverse voltages from being applied to the photovoltaics during normal operations. Even when a part of the photovoltaics is shaded and so forth, the current of the photovoltaics is not blocked immediately, and the bypass diode is effective in allowing the other part of the photovoltaics to generate power, whereby the power generation capacity can be restrained from decreasing. Further, when the bypass diode is in an open-mode failure, the detection unit detects the open-mode failure, and the blocking unit blocks the current of the photovoltaics, whereby the photovoltaics can be prevented from heating and breaking. That is, without necessitating any specific operation separately, measures against the open-mode failure of the bypass diode are taken automatically, so as to deter damages more serious than the open-mode failure from occurring. Therefore, one aspect of the present invention makes it possible to improve reliability while securing the power generation capacity. By "a reverse voltage is applied to the photovoltaics" is meant a state where the positive electrode of the photovoltaics has a potential lower than that of the negative electrode (the same hereinafter).

Preferably, the detection unit detects the open-mode failure of the bypass diode when a predetermined reverse voltage value is applied to the photovoltaics, the predetermined reverse voltage value being a voltage drop value greater than that of the photovoltaics occurring when a current having a maximum current value flows through the bypass diode. In this case, the detection unit can accurately detect the open-mode failure of the bypass diode.

Preferably, the maximum current value is a short-circuit current value of the photovoltaics occurring when the whole surface thereof is irradiated with solar light having an amount of solar radiation at a solar constant. In this case, the detection unit can more accurately detect the open-mode failure of the bypass diode.

Preferably, the photovoltaic module comprises a signal transmitter for transmitting a signal including a failure signal when the detection unit detects the open-mode failure of the bypass diode and a signal receiver for receiving the signal from the signal transmitter, while the blocking unit blocks the current of the photovoltaics in response to the reception of the signal by the signal receiver. In this case, the blocking unit can favorably block the current of the photovoltaics when the bypass diode is in the open-mode failure.

Preferably, the signal transmitter transmits the signal further including a characteristic value signal for identifying the photovoltaic module having the bypass diode in the open-mode failure. In this case, the photovoltaic module in the open-mode failure can be identified according to the characteristic value signal of the signal transmitted from the signal transmitter, for example.

Preferably, the photovoltaic module comprises a display device for displaying information concerning the open-mode failure of the bypass diode in response to the reception of the signal by the signal receiver. In this case, the open-mode failure can be displayed by the display device, so as to be noticed.

The photovoltaic power generation system in accordance with one aspect of the present invention is a photovoltaic power generation system comprising at least one photovoltaic string constituted by a plurality of photovoltaic modules connected in series, each of the photovoltaic modules having a photovoltaics for generating power by utilizing solar light, a bypass diode connected in parallel with the photovoltaics, and a detection unit for detecting an open-mode failure of the bypass diode, the system comprising a blocking unit for blocking a current of the photovoltaics when the detection unit detects the open-mode failure of the bypass diode.

This photovoltaic power generation system also exhibits operations and effects similar to those of the above-mentioned photovoltaic module. That is, during normal operations, high reverse voltages can be prevented from being applied to the photovoltaics, while the power generation capacity can be restrained from decreasing. Further, when the bypass diode is in the open-mode failure, the detection unit detects the open-mode failure, and the blocking unit blocks the current of the photovoltaics, whereby the photovoltaics can be prevented from heating and breaking. Therefore, reliability can easily be improved while securing the power generation capacity.

Here, as mentioned above, it is preferred for the detection unit to detect the open-mode failure of the bypass diode when a predetermined reverse voltage value is applied to the photovoltaics, the predetermined reverse voltage value being a voltage drop value greater than that of the photovoltaics occurring when a current having a maximum current value flows through the bypass diode. The detection unit can accurately detect the open-mode failure of the bypass diode also in this case.

Preferably, the maximum current value is a short-circuit current value of the photovoltaics occurring when the whole surface thereof is irradiated with solar light having an amount of solar radiation at a solar constant as in the foregoing. The detection unit can more accurately detect the open-mode failure of the bypass diode also in this case as mentioned above.

Preferably, the system comprises a signal transmitter for transmitting a signal including a failure signal when the detection unit detects the open-mode failure of the bypass diode and a signal receiver for receiving the signal from the signal transmitter, while the blocking unit blocks the current of the photovoltaic string in response to the reception of the signal by the signal receiver. The blocking unit can favorably block the current of the photovoltaics when the bypass diode is in the open-mode failure also in this case.

Preferably, the signal transmitter transmits a signal further including a characteristic value signal for identifying the photovoltaic module having the bypass diode in the open-mode failure, while the blocking unit blocks the current of the photovoltaic string including the photovoltaic module corresponding to the characteristic value signal of the signal when the signal receiver receives the signal. In this case, the current of the photovoltaic string of the photovoltaic module in the open-mode failure is blocked.

Preferably, the system comprises a display device for displaying information concerning the open-mode failure of the bypass diode in response to the reception of the signal by the signal receiver. In this case, the open-mode failure can be displayed by the display device, so as to be noticed.

Preferably, the system comprises a display device for displaying information concerning the open-mode failure of the bypass diode in response to the reception of the signal by the signal receiver, the signal transmitter transmits a signal further including a characteristic value signal for identifying the photovoltaic module having the bypass diode in the open-mode failure, the blocking unit blocks the current of the photovoltaic string including the photovoltaic module corresponding to the characteristic value signal of the signal when the signal receiver receives the signal, and the display device displays information including specific information for specifying the photovoltaic module corresponding to the characteristic value signal of the signal when the signal receiver receives the signal. In this case, the current of the photovoltaic string of the photovoltaic module in the open-mode failure is blocked. At the same time, the photovoltaic module in which the bypass diode is in the open-mode failure can be specified by the specific information displayed by the display device.

Each of the detection unit, blocking unit, signal transmitter, signal receiver, and display device may be either mechanically integrated with or separated from the photovoltaic module.

This aspect of the present invention can easily improve reliability while securing a power generation capacity.

From the following reason, it may become difficult for the above-mentioned technique to determine whether or not the bypass diode fails. That is, even when the bypass diode is not in the open-mode failure, there is a case where a reverse voltage is applied to some extent to the photovoltaics shielded from light, whereby the heating of the photovoltaics is detected. The extent of the heating depends on the solar radiation intensity at the time, the state of light shielding, the current density of the photovoltaics, the heat dissipation state of the photovoltaics, the shunt resistance component of the photovoltaics, and the like and cannot be expected unconditionally. This makes it very hard to distinguish between the heating in a normal range and that caused by failures of the bypass diode, whereby the open-mode failure of the bypass diode may not be detected accurately.

In view of the circumstances mentioned above, it is an object of one aspect of the present invention to provide a failure detection device and method which can accurately detect an open-mode failure of a bypass diode.

For achieving the above-mentioned object, the inventors conducted diligent studies and, as a result, have found that a voltage drop value greater than that of a photovoltaics occurring when a current having a maximum current value flows through a bypass diode is applied to the photovoltaics when the bypass diode is in the open-mode failure. The open-mode failure of the bypass diode has been seen to be accurately detectable according to this finding, whereby the present invention has been completed.

That is, the failure detection device included in a photovoltaics system in accordance with one aspect of the present invention is a failure detection device for detecting a failure in a photovoltaic module having a photovoltaics for generating power by utilizing solar light and a bypass diode connected in parallel with the photovoltaics, the detection unit detecting an open-mode failure of the bypass diode when a predetermined reverse voltage value is applied to the photovoltaics, the predetermined reverse voltage value being a voltage drop value greater than that of the photovoltaics occurring when a current having a maximum current value flows through the bypass diode.

In this failure detection device, the above-mentioned finding can favorably be applied to the open-mode failure of the bypass diode, whereby the open-mode failure can be detected accurately. By "a reverse voltage is applied to the photovoltaics" is meant a state where the positive electrode of the photovoltaics has a potential lower than that of the negative electrode (the same hereinafter).

Preferably, the maximum current value is a short-circuit current value of the photovoltaics occurring when the whole surface thereof is irradiated with solar light having an amount of solar radiation at a solar constant. In this case, the open-mode failure of the bypass diode can be detected more accurately. This is because it has further been found that the maximum current value flowing through the bypass diode is the short-circuit current value of the photovoltaics occurring when the whole surface thereof is irradiated with solar light having an amount of solar radiation at a solar constant.

Preferably, the failure detection device comprises a signal transmitter for transmitting a signal including a failure signal when the detection unit detects the open-mode failure of the bypass diode, a signal receiver for receiving the signal from the signal transmitter, and a display device for displaying information concerning the open-mode failure of the bypass diode in response to the reception of the signal by the signal receiver. In this case, the open-mode failure can be displayed by the display device, so as to be noticed.

Preferably, the signal transmitter transmits a signal further including a characteristic value signal for identifying the photovoltaic module having the bypass diode in the open-mode failure. In this case, the photovoltaic module in the open-mode failure can be identified according to the characteristic value signal of the signal transmitted from the signal transmitter, for example.

The failure detection device included in a photovoltaics system in accordance with one aspect of the present invention is a failure detection device for detecting a failure in a photovoltaic power generation system comprising at least one photovoltaic string constituted by a plurality of photovoltaic modules connected in series, each of the photovoltaic modules having a photovoltaics for generating power by utilizing solar light and a bypass diode connected in parallel with the photovoltaics, the failure detection device comprising a detection unit for detecting an open-mode failure of the bypass diode, the detection unit detecting the open-mode failure of the bypass diode when a predetermined reverse voltage value is applied to the photovoltaics, the predetermined reverse voltage value being a voltage drop value greater than that of the photovoltaics occurring when a current having a maximum current value flows through the bypass diode.

This failure detection device can also favorably apply the above-mentioned finding to the open-mode failure of the bypass diode and accurately detect the open-mode failure.

Preferably, the maximum current value is a short-circuit current value of the photovoltaics occurring when the whole surface thereof is irradiated with solar light having an amount of solar radiation at a solar constant. In this case, the detection unit can more accurately detect the open-mode failure of the bypass diode.

Preferably, the failure detection device comprises a signal transmitter for transmitting a signal including a failure signal when the detection unit detects the open-mode failure of the bypass diode, a signal receiver for receiving the signal from the signal transmitter, and a display device for displaying information concerning the open-mode failure of the bypass diode in response to the reception of the signal by the signal receiver. In this case, the open-mode failure can be displayed by the display device, so as to be noticed.

Preferably, the signal transmitter transmits a signal further including a characteristic value signal for identifying the photovoltaic module having the bypass diode in the open-mode failure, while the display device displays information including specific information for specifying the photovoltaic module corresponding to the characteristic value signal of the signal when the signal receiver receives the signal. In this case, the bypass diode can specify the photovoltaic module in the open-mode failure according to the specific information displayed by the display device.

The failure detection method in accordance with one aspect of the present invention comprises a detection step of detecting an open-mode failure of a bypass diode connected in parallel with a photovoltaics for generating power by utilizing solar light, the detection step detecting the open-mode failure of the bypass diode when a predetermined reverse voltage value is applied to the photovoltaics, the predetermined reverse voltage value being a voltage drop value greater than that of the photovoltaics occurring when a current having a maximum current value flows through the bypass diode.

This failure detection method can also favorably apply the above-mentioned finding to the open-mode failure of the bypass diode and accurately detect the open-mode failure.

Preferably, the maximum current value is a short-circuit current value of the photovoltaics occurring when the whole surface thereof is irradiated with solar light having an amount of solar radiation at a solar constant. In this case, the open-mode failure of the bypass diode can be detected more accurately as mentioned above.

Preferably, the method comprises a signal transmission step of transmitting a signal including a failure signal when the open-mode failure of the bypass diode is detected by the detection step, a signal reception step of receiving the signal transmitted by the signal transmission step, and a display step of displaying information concerning the open-mode failure of the bypass diode in response to the reception of the signal by the signal reception step. In this case, the open-mode failure can be displayed by the display step, so as to be noticed.

Preferably, the signal transmission step transmits a signal including a characteristic value signal for identifying the photovoltaic module having the bypass diode in the open-mode failure. In this case, the photovoltaic module in the open-mode failure can be identified according to the characteristic value signal of the transmitted signal, for example.

Each of the detection unit, blocking unit, signal transmitter, signal receiver, and display device may be either mechanically integrated with or separated from the photovoltaic module.

One aspect of the present invention makes it possible to detect the open-mode failure of the bypass diode accurately.

In the following, preferred embodiments will be explained in detail with reference to the drawings. In the following, the same or equivalent constituents will be referred to with the same signs while omitting their overlapping descriptions.

**First Embodiment**

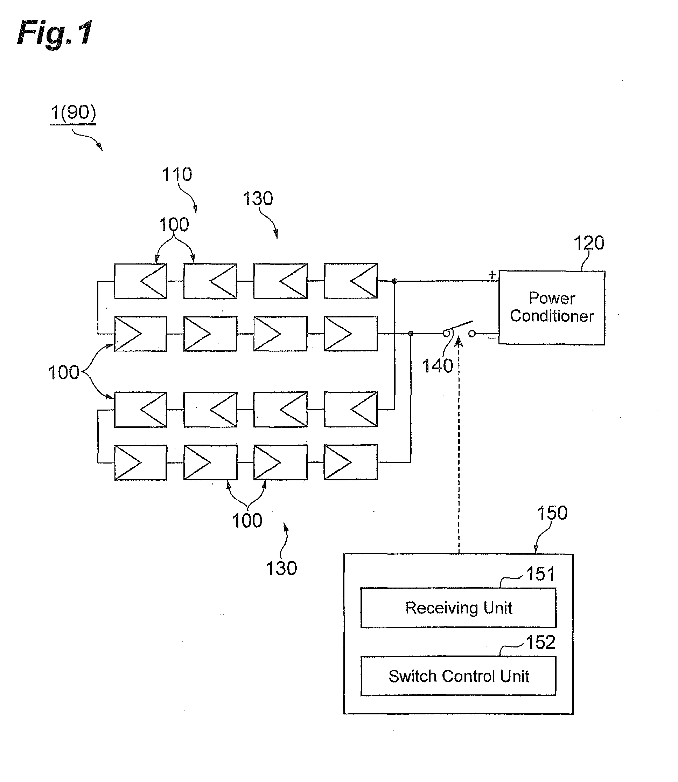

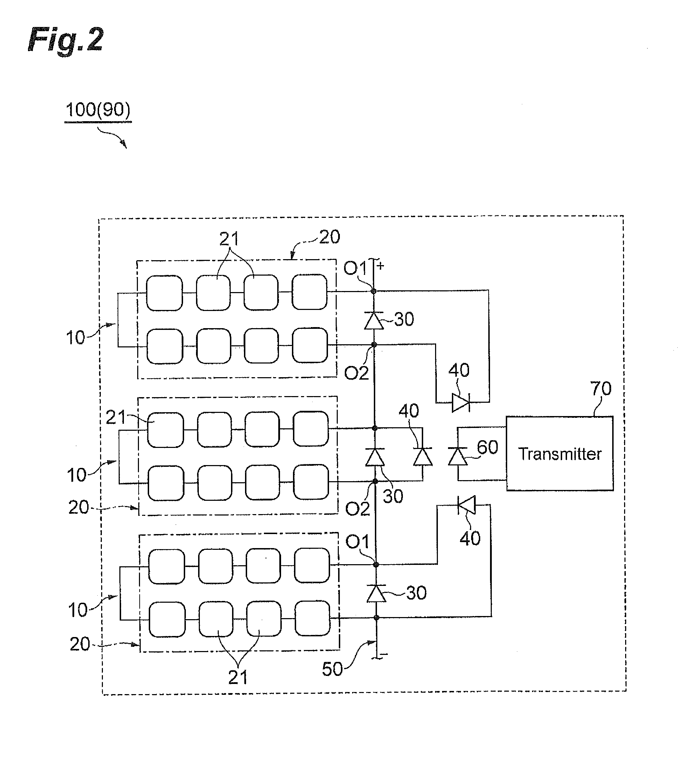

The first embodiment will now be explained. Fig. 1 is a structural diagram illustrating a photovoltaic power generation system including the failure detection device in accordance with the first embodiment, while Fig. 2 is a structural diagram of a photovoltaic module in the photovoltaic power generation system of Fig. 1. As illustrated in Fig. 1, the failure detection device 90 of this embodiment is one for detecting failures in photovoltaic modules 100 and comprises at least an LED (Light Emitting Diode) 40 and a light-receiving element 60 which serve as a detection unit, a transmitter 70 as a signal transmitter, a receiving unit 151 as a signal receiver, and a switch 140 and a switch control unit 152 which serve as a blocking unit. In the following, the failure detection device 90 will be explained together with the photovoltaic modules 100.

The photovoltaic power generation system 1 is a power generation system which generates power by utilizing photovoltaic energy, of a grid connection type having an output voltage of 200 V or higher, and installed at a high place such as a roof, for example. The photovoltaic power generation system 1 has a photovoltaic array 110 and a power conditioner 120.

The photovoltaic array 110 converts photovoltaic energy into electric energy, which is fed as a DC output to the power conditioner 120. The photovoltaic array 110 comprises at least one photovoltaic string 130 constituted by a plurality of photovoltaic modules 100 connected in series. Here, eight photovoltaic modules 100 are connected in series, so as to construct one photovoltaic string 130, and two such photovoltaic strings 130 are connected in parallel, so as to construct the photovoltaic array 110. The photovoltaic array 110 is connected to the power conditioner 120 through the switch 140.

The power conditioner 120 converts the DC output supplied from the photovoltaic array 110 into an AC output and feeds the AC output to a power grid (e.g., commercial power grid) downstream thereof. The power conditioner 120 has an operating voltage control function for controlling the operating voltage of the photovoltaic array 110 so as to yield the maximum output of the photovoltaic array 110 and a grid protection function for safely stopping the system when an abnormality is detected in the power grid and so forth. The power conditioner 120 may be of either a transformer insulation type having an insulated transformer or a transformerless (non-insulated) type.

The switch 140 is one for controlling the electric connection between the photovoltaic array 110 and the power conditioner 120. Those employable as the switch 140 may have any structures as long as they can block a current, and their examples include semiconductor switches such as FET (Field Effect Transistor) and IGBT (Insulated Gate Bipolar Transistor) and electromagnetic switches such as mechanical relays. The switch 140 is closed during normal operations, so as to connect the photovoltaic array 110 and the power conditioner 120 to each other, but is opened when a bypass diode 30 is in an open-mode failure, so as to separate them from each other (as will be explained later in detail).

The photovoltaic module 100 is constructed into a panel and comprises a plurality of (3 here) photovoltaic units 10 connected in series as illustrated in Fig. 2. Each of the plurality of photovoltaic units 10 includes a photovoltaic cluster (photovoltaics) 20, the bypass diode 30, and an LED 40.

The photovoltaic cluster 20 includes a plurality of photovoltaic cells 21 connected in series and generates power by utilizing solar light. The plurality of photovoltaic cells 21 are juxtaposed in a matrix and secured to an aluminum frame while being covered with tempered glass on their light-receiving surface side. For example, crystalline photovoltaic cells each having an output voltage of 0.5 V are used as the photovoltaic cells 21.

The bypass diode 30 is connected in parallel with the photovoltaic cluster 20. For example, a Schottky barrier diode is used as the bypass diode 30 in order to lower the forward voltage and shorten the reverse recovery time. The bypass diode 30 is disposed such that a current flows therethrough when a reverse voltage is applied to the photovoltaic cluster 20, and its forward direction is opposite to the forward direction of equivalent parasitic diodes of the photovoltaic cells 21 within the photovoltaic cluster 20.

Specifically, the cathode side of the bypass diode 30 is connected to the positive electrode side of the photovoltaic cluster 20 on an electric line 50 connecting the photovoltaic clusters 20 in series. The anode side of the bypass diode 30 is connected to the negative electrode side of the photovoltaic cluster 20 on the electric line 50.

The LED 40 is a light-emitting element connected in parallel with the photovoltaic cluster 20 and bypass diode 30 and constitutes a detection unit for detecting an open-mode failure of the bypass diode 30. The LED 40 is disposed such that its forward direction is opposite to the forward direction of equivalent parasitic diodes of the photovoltaic cells 21 in the photovoltaic cluster 20 and so as to emit light when a predetermined reverse voltage value is applied to the photovoltaic cluster 20. The predetermined reverse voltage is set by providing an IV curve (current-voltage curve) characteristic of the LED 40 as explained in detail in the following, for example, so as to cause the LED 40 to emit light when the bypass diode 30 falls into the open-mode failure.

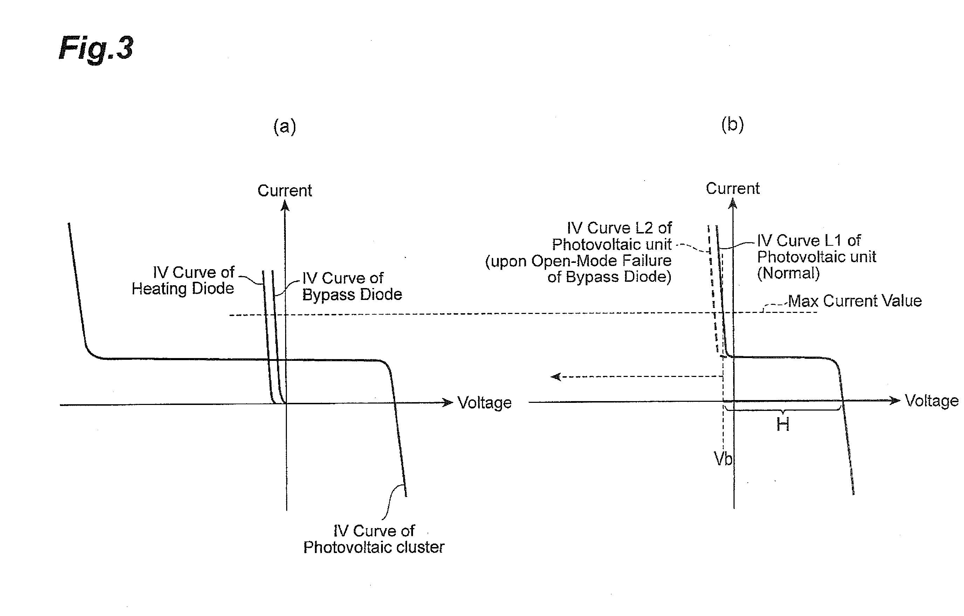

Fig. 3(a) is a graph illustrating IV curve characteristics of individual elements in the photovoltaic unit, while Fig. 3(b) is a graph illustrating a combined IV curve characteristic of the elements in the photovoltaic unit. When the bypass diode 30 functions normally (a current flows through the bypass diode 30), as illustrated in Figs. 3(a) and 3(b), the voltage value in the photovoltaic unit 10 falls within a normal voltage range H, while its lower limit is a voltage drop value Vb at the time when the maximum current value flows through the bypass diode 3 0. In other words, the largest voltage drop occurs in the photovoltaic unit 10 when the maximum current value flows through the bypass diode 30. When a voltage drop greater than the voltage drop value Vb is generated, on the other hand, it can be determined that the bypass diode 30 is in an open-mode failure (fails while no current flows therethrough), so that no current flows through the bypass diode 30.

Here, the maximum current value is a short-circuit current value of the photovoltaic cluster 20 exposed to the maximum solar irradiance conceivable and can be regarded as a short-circuit current value corresponding to a solar constant which is the solar irradiance before being absorbed and scattered by the atmosphere. Specifically, since the rated value of the short-circuit current value of the photovoltaic cluster 20 is typically a short-circuit current value of solar irradiance in a normal state, the maximum current value can be the short-circuit current value of the photovoltaics when the whole surface of the photovoltaic cluster 20 is irradiated with solar light having an amount of solar radiation at a solar constant, and the value of the following expression (1) can be used as the maximum current value. Here, by "the whole surface" is meant to permit errors in manufacture and design and include nearly or substantially the whole surface.

$$\text{Rated short-circuit current value} \times \text{solar constant/solar irradiance in the normal state } (= 1 \text{ kW/m}^2) \qquad (1)$$

Therefore, this embodiment takes the voltage drop value Vb as a reference and a voltage drop value greater than the former value as a predetermined reverse voltage value and employs the LED 40 having such an IV curve characteristic as to allow a current to flow therein to emit light when the predetermined reverse voltage value is applied to the photovoltaic cluster 20. In other words, the LED 40 is constituted by a diode having an IV curve characteristic which allows a forward current to flow therein upon a voltage drop value greater than that in the IV curve characteristic of the bypass diode 30.

Since the voltage drop value may change slightly according to the temperature in the surroundings of the diode and the like, a difference $\Delta V$ is preferably set between the voltage drop value Vb and the predetermined reverse voltage value in order to avoid malfunctions. The difference $\Delta V$ is a margin for preventing malfunctions with respect to an operational threshold of less than 1 V and thus can employ such a small value. The difference ΔV can further improve the reliability of the system.

The cathode side of the LED 40 is connected to a junction O1 between the positive electrode side of the photovoltaic cluster 20 and the bypass diode 30 on the electric line 50. The anode side of the LED 40 is connected to a junction 02 between the negative electrode side of the photovoltaic cluster 20 and the bypass diode 30 on the electric line 50.

The photovoltaic module 100 also comprises the light-receiving element 60 and the transmitter 70. The light-receiving element 60 receives LED light emitted by at least one LED 40 and constitutes a detection unit for detecting an open-mode failure of the bypass diode 30. The light-receiving element 60, which is arranged (optically coupled) so as to be able to receive the LED light from each LED 40 favorably, is disposed close to each LED 40 here. In response to the reception of the LED light by the light-receiving element 60 (when the LED light is received), the transmitter 70 transmits a signal including a failure signal concerning the open-mode failure of the bypass diode 30 to the receiving unit 151, which will be explained later.

Returning to Fig. 1, this embodiment is equipped with a controller 150 for controlling the circulation of the current in the photovoltaic array 110. The controller 150 includes the receiving unit 151 and the switch control unit 152.

The receiving unit 151 receives the signal transmitted from the transmitter 70 (see Fig. 2) of the photovoltaic module 100. The switch control unit 152 blocks the current (charge flow) of the photovoltaic array 110 in response to the reception of the signal by the receiving unit 151. Specifically, when the signal from the transmitter 70 is received by the receiving unit 151, the switch control unit 152 controls and opens the switch 140, so as to separate the photovoltaic array 110 from the power conditioner 120, thereby blocking the current of the photovoltaic array 110.

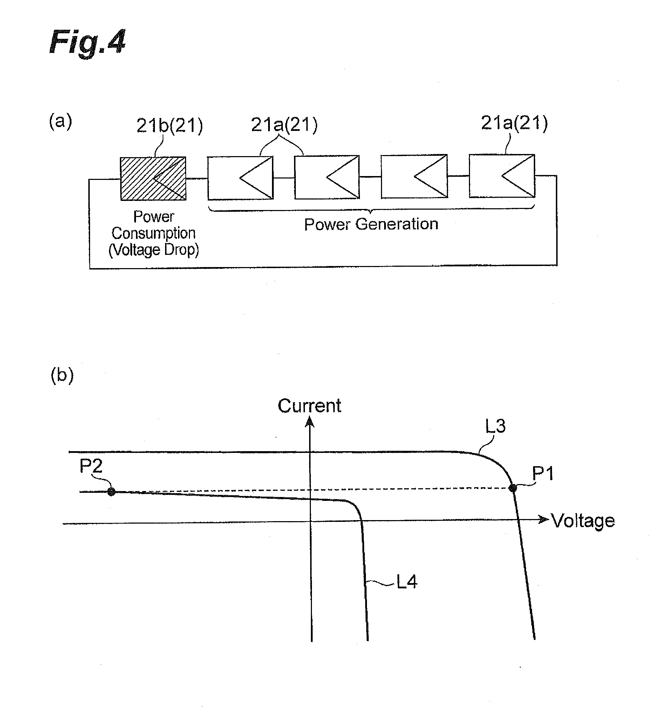

Fig. 4(a) is a structural diagram for explaining a bypass diode, while Fig. 4(b) is a graph illustrating IV curve characteristics of a photovoltaic cluster for explaining the bypass diode. In Fig. 4(b), L3 and L4 illustrate the IV curve characteristics of highly and lowly insolated photovoltaic cells 21a, 21b, respectively. Since a plurality of photovoltaic cells 21 are connected in series as the photovoltaic cluster 20 in the photovoltaic unit 10, a reverse voltage may occur in a part of the photovoltaic cells 21 because of variations in characteristics, differences in solar radiation intensity, and the like among the photovoltaic cells 21.

When highly insolated photovoltaic cells 21a with a favorable amount of solar radiation and a lowly insolated photovoltaic cell 21b with a lower amount of solar radiation are short-circuited as illustrated in Fig. 4(a), their total voltage is 0, whereby their respective operating points are P1, P2 as illustrated in Fig. 4(b). Hence, it is seen that, while the highly insolated photovoltaic cells 21a generate power, the lowly insolated photovoltaic cell 21b consumes the same power as generated and thus has a reverse voltage applied thereto.

Therefore, connecting the bypass diode 30 in parallel with the photovoltaic cluster 20, so as to suppress the voltage loss Vloss of the photovoltaic cluster 20, can prevent the voltage loss Vcell of the lowly insolated photovoltaic cell 21b from greatly exceeding the voltage gain Vg as represented by the following expression (2):

$$\mathrm{Vcell} = \mathrm{Vloss} + \mathrm{Vg} \qquad (2)$$

where
Vcell is the voltage loss of the lowly insolated photovoltaic cell 21b;
Vloss is the voltage loss of the photovoltaic cluster 20; and
Vg is the voltage gain of the photovoltaic cluster 20.

As a result, in the photovoltaic units 10 (the photovoltaic modules 100, photovoltaic strings 130, photovoltaic array 110, and photovoltaic power generation system 1), the bypass diode 30 can act to restrain the reverse voltage applied to the photovoltaic cell 21b from exceeding the total voltage occurring in the other photovoltaic cells 21a constituting the photovoltaic cluster 20, whereby high safety can be secured. Even when the lowly insolated photovoltaic cell 21b exists in the photovoltaic cluster 20, the bypass diode 30 allows a large current from another photovoltaic cluster 20 to pass therethrough, whereby the amount of power generation of the latter photovoltaic cluster 20 can be maintained. This can reduce the drop in the amount of power generation in the whole system.

When the bypass diode 30 is in the open-mode failure for some reason here, there is a fear of a large voltage being applied to a specific photovoltaic cell 21 as mentioned above, thus generating power and damaging the module, which makes it preferable to block currents from flowing through the photovoltaic unit 10 or photovoltaic module 100. When the bypass diode 30 operates normally, on the other hand, in order to secure a power generation capacity, it is preferable to prevent the photovoltaic unit 10 or photovoltaic module 100 from being blocked erroneously and let the bypass diode 30 function securely.

In this regard, even if a reverse voltage is applied to the photovoltaic cluster 20 when the bypass diode 30 operates normally in the photovoltaic unit 10 of this embodiment, as illustrated in Fig. 3(b), the IV curve characteristic L1, which is dominated by the bypass diode 30 and has the normal voltage range H, causes the bypass diode 30 to function so as to prevent currents from flowing substantially through the LEDs 40. Hence, the LEDs 40 do not emit light, so that the switch 140 is kept closed, whereby the photovoltaic array 110 is not blocked.

When the bypass diode 30 is in the open-mode failure, on the other hand, the open-mode failure can be detected by the failure detection device 90. That is, since the IV curve of the photovoltaic unit 10 shifts to the IV curve characteristic L2 dominated by the LED 40, when a predetermined reverse voltage (a voltage drop value greater than the voltage drop value Vb) is applied to the photovoltaic cluster 20 in any of a plurality of photovoltaic modules 100, a current flows through the LED 40, so that the LED 40 emits LED light, which is received by the light-receiving element 60, whereby the open-mode failure of the bypass diode 30 is detected (detection step).

In the failure detection device 90, when the LED light is received by the light-receiving element 60, the transmitter 70 transmits a signal to the receiving unit 151 (signal transmission step), and this signal is received by the receiving unit 151 (signal reception step). When the signal is received by the receiving unit 151, the switch control unit 152 opens the switch 140 under its control, so as to separate the photovoltaic array 110 from the power conditioner 120 (electric line 50), thereby safely blocking the current of the photovoltaic array 110 (blocking step).

In this embodiment, as in the foregoing, the open-mode failure of the bypass diode 30 is detected when a predetermined reverse voltage value is applied to the photovoltaic cluster 20, while the predetermined reverse voltage value is a voltage drop value greater than that of the photovoltaic cluster 20 occurring when a current having the maximum current value flows through the bypass diode 30. As a consequence, the open-mode failure of the bypass diode 30 can be detected accurately by utilizing the above-mentioned characteristic of the photovoltaic unit 10. Since the maximum current value is the short-circuit current value of the photovoltaic cluster 20 occurring when the whole surface thereof is irradiated with solar light having an amount of solar radiation at a solar constant, the open-mode failure of the bypass diode 30 can be detected more accurately.

While this embodiment uses the LED 40 and light-receiving element 60 as a detection unit, a detector which directly detects whether or not a predetermined reverse voltage value is applied to the photovoltaic cluster 20 (e.g., one detecting the potential difference of the photovoltaic cluster 20) may be used. In this case, the transmitter 70 transmits a signal when the detector detects that the predetermined reverse voltage value is applied to the photovoltaic cluster 20.

As mentioned above, this embodiment can prevent high reverse voltages from being applied to the photovoltaic cluster 20 and eventually to the photovoltaic cells 21 during normal operations and, even when one of the photovoltaic cells 21 is shaded and so forth, does not immediately block the current of the photovoltaic unit 10, but can effectively utilize the power generation of other photovoltaic clusters 20, thereby restraining the power generation capacity from decreasing.

In addition, the open-mode failure of the bypass diode 30 can be detected by the LED 40 and light-receiving element 60, and the switch control unit 152 can control the switch 140, so as to block the current of the photovoltaic array 110. This can block the current of the photovoltaic array 110 securely and easily at low cost, thereby preventing the photovoltaic array 110 from heating and breaking. That is, without necessitating any specific operation separately, measures against the open-mode failure of the bypass diode 30 are taken automatically, so as to deter damages more serious than the open-mode failure from occurring. This can block the current of the photovoltaic cluster 20 when necessary to do so, but allows it to flow otherwise, thus making it possible to improve reliability easily while securing a power generation capacity.

The controller 150, which is independently constructed as a separate member in this embodiment, may be incorporated in the power conditioner 120. A resistance having a predetermined resistance value may further be disposed on an electric line 51 which is in parallel with the photovoltaic cluster 20 and bypass diode 30 and has the LED 40 arranged thereon. This can securely prevent very weak currents from flowing through the LED 40 and making it emit light during normal operations of the bypass diode 30.

While the failure detection device 90 (failure detection method) of this embodiment is constructed such as to detect a failure within the photovoltaic module 100, this is not restrictive. The failure detection device 90 (failure detection method) may be constructed such as to detect a failure within any of the photovoltaic power generation system 1, photovoltaic arrays 110, photovoltaic strings 130, and photovoltaic modules 100.

The failure detection device 90 of this embodiment may lack at least one of the transmitter 70, the receiving unit 151, and the switch 140 and switch control unit 152. Similarly, the failure detection method of this embodiment may lack at least one of the signal transmission, signal reception, and blocking steps.

While the switch 140 and switch control unit 152 serving as a blocking unit are provided separately from the photovoltaic module 100 (i.e., on the outside of the photovoltaic module 100) in this embodiment, a whole or part of the blocking unit may be mounted in the photovoltaic module 100 (i.e., may be disposed within the photovoltaic module 100).

**Second Embodiment**

The second embodiment will now be explained. This embodiment will be explained mainly in terms of differences from the above-mentioned first embodiment.

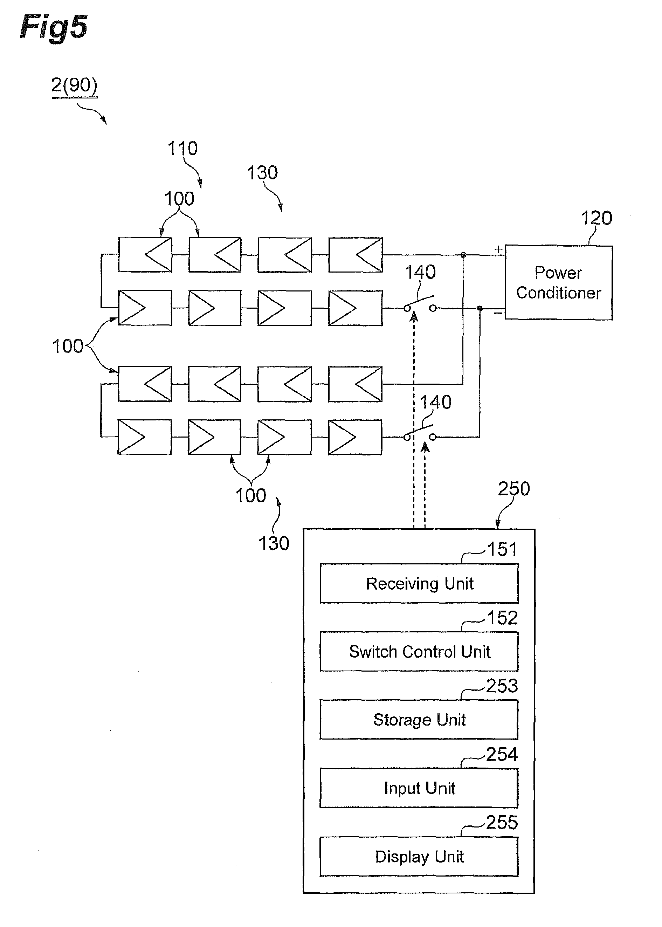

Fig. 5 is a structural diagram illustrating a photovoltaic power generation system including the failure detection device in accordance with the second embodiment. This embodiment differs from the above-mentioned first embodiment mainly in that the current is blocked for each photovoltaic string 130 instead of each photovoltaic array 110 as in the above-mentioned embodiment.

Specifically, in this embodiment, a signal transmitted from the transmitter 70 in each of the plurality of photovoltaic modules 100 includes a specific value signal (e.g., a signal concerning the module number) which varies among the plurality of photovoltaic modules 100. That is, each transmitter 70 transmits a signal further including a specific value signal for identifying the photovoltaic module 100 in which the bypass diode 30 is in the open-mode failure.

In this embodiment, as illustrated in Fig. 5, the photovoltaic strings 130 in the photovoltaic power generation system 2 are connected to the power conditioner 120 through respective switches 140. When the receiving unit 151 receives the signal from the transmitter 70, the switch control unit 152 reads the specific value signal from the received signal and specifies the photovoltaic string 130 to which the photovoltaic module 100 corresponding to the specific value signal of the signal belongs. Then, the switch control unit 152 controls and opens the switch 140 provided for the specified photovoltaic string 130, so as to separate the specified photovoltaic string 130 from the power conditioner 120, thereby blocking the current of the photovoltaic string 130.

The failure detection device 90 of this embodiment further comprises a storage unit 253, an input unit 254, and a display unit (display device) 255 within the controller 250. The storage unit 253 stores the read specific value signal. The input unit 254 detects an operation input made by a user and causes the display unit 255 to display information according to the detected operation input. The display unit 255 displays the information according to the operation input from the input unit 254.

When the open-mode failure of the bypass diode 30 is detected while the bypass diode 30 is in the open-mode failure in this embodiment, for example, the transmitter 70 transmits a signal further including the specific value signal (signal transmission step). Subsequently, when this signal is received by the receiving unit 151, the specific value signal included therein is read, whereby the module number of the photovoltaic module 100 including the bypass diode 30 in the open-mode failure is specified.

Subsequently, the switch 140 is controlled by the switch control unit 152 such that only the photovoltaic string 130 to which the photovoltaic module 100 bearing the above-mentioned module number is separated from the power conditioner 120 (blocking step). As a result, the current of the photovoltaic string 130 is blocked safely. At the same time, the occurrence of the open-mode failure in the bypass diode 30 (information concerning the open-mode failure) is displayed on the display unit 255, so that the user is notified of the open-mode failure and alerted (display step).

Concurrently, the specified module number is stored and contained in the storage unit 253 (storage step). As a result, when a user operates an operation button of the input unit 254, for example, the module number stored in the storage unit 253 is further displayed as specific information on the display unit 255, and which of the plurality of photovoltaic modules 100 has the bypass diode 30 in the failure is seen (validation step).

As in the foregoing, this embodiment also exhibits effects similar to those of the former embodiment, i.e., the effects of easily improving reliability while securing a power generation capacity and of accurately detecting the open-mode failure of the bypass diode 30. Since the signal transmitted from the transmitter 70 includes the specific value signal as mentioned above, this embodiment makes it possible to identify the photovoltaic module in the open-mode failure according to the specific value signal.

This embodiment blocks the current of only the photovoltaic string 130 to which the photovoltaic module 100 corresponding to the specific value signal belongs. Therefore, while the current can be blocked for only the specific photovoltaic string 130 to which the photovoltaic module 100 in the open-mode failure belongs, the power generation can favorably be continued by photovoltaic strings 130 other than the specific photovoltaic string 130.

In this embodiment, information concerning the open-mode failure of the bypass diode 30 can be displayed on the display unit 255 in response to the reception of the signal by the receiving unit 151. This allows the display unit 255 to notify the user of the open-mode failure.

This embodiment enables the display unit 255 to display specific information for specifying the photovoltaic module 100 corresponding to the specific value signal. This makes it possible to specify the photovoltaic module 100 in the open-mode failure.

The failure detection device 90 of this embodiment may lack at least one of the storage unit 253 and input unit 254. Similarly, the failure detection method of this embodiment may lack at least one of the storage and validation steps.


Third Embodiment


The third embodiment will now be explained. This embodiment will be explained mainly in terms of differences from the above-mentioned first embodiment.

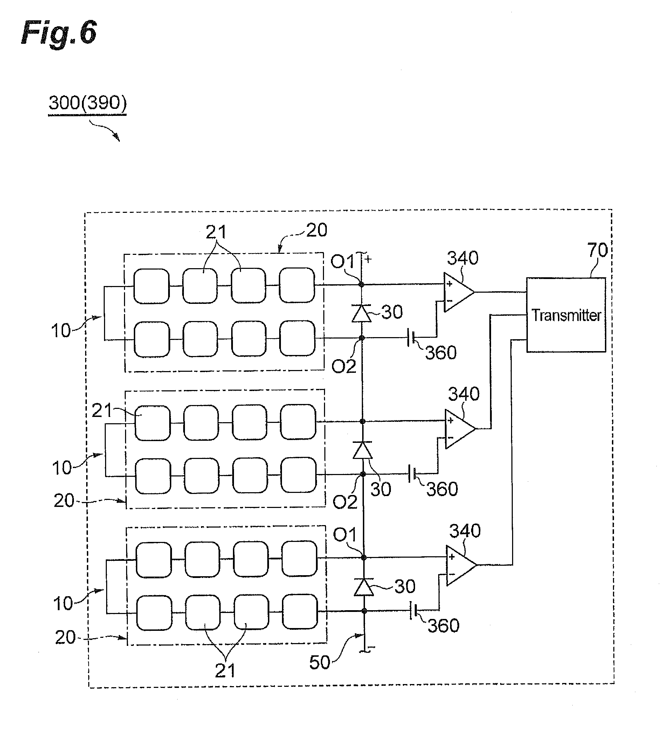

Fig. 6 is a structural diagram illustrating a photovoltaic power generation system including the failure detection device in accordance with the third embodiment. As illustrated in Fig. 6, this embodiment differs from the above-mentioned first embodiment mainly in that a photovoltaic module 300 is equipped with comparators 340 and a reference power supply 360 as a detection unit in place of the LED 40 and light-receiving element 60 (see Fig. 2).

Each comparator 340 compares input voltages on the positive and negative electrode sides with each other and outputs the result of the comparison as a binary output voltage. The comparator 340 is disposed so as to connect in parallel with the photovoltaic cluster 20 in each photovoltaic unit 10. Specifically, an input terminal on the positive electrode side of each comparator 340 is connected to a junction O1 between the positive electrode side of the photovoltaic cluster 20 and the bypass diode 30, while an input terminal on the negative electrode side thereof is connected to a junction 02 between the negative electrode side of the photovoltaic cluster 20 and the bypass diode 30. An output terminal of each comparator 340 is connected to the transmitter 70.

The reference power supply 360 applies a reference potential difference corresponding to the above-mentioned predetermined reverse voltage value (a voltage drop value greater than the voltage drop value Vb) to the input terminal on the negative electrode side of the comparator 340. The reference power supply 360 is disposed on an electric line between the input terminal on the negative electrode side of the comparator 340 and the junction O2. The reference power supply 360 allows the comparator 340 to output an output voltage as an OFF signal to the transmitter 70 when the predetermined reverse voltage value is applied to the photovoltaic cluster 20. When the OFF signal is inputted from any of the comparators 340, the transmitter 70 of this embodiment transmits a signal to the receiving unit 151.

When the predetermined reverse voltage value (a voltage drop value greater than the voltage drop value Vb) is applied to the photovoltaic cluster 20 in any of the plurality of photovoltaic modules 100 while the bypass diode 30 is in the open-mode failure in this embodiment, the comparator 340 outputs the OFF signal to the transmitter 70 (detection step). As a consequence, the open-mode failure of the bypass diode 30 is detected. When the OFF signal is outputted to the transmitter 70, the transmitter 70 transmits a signal to the receiving unit 151 (signal transmission step). As a result, the current of the photovoltaic array 110 is blocked safely.

As in the foregoing, this embodiment also exhibits effects similar to those of the previous embodiments, i.e., the effects of easily improving reliability while securing a power generation capacity and of accurately detecting the open-mode failure of the bypass diode 30. Other members concerning the comparators 340 such as general power supplies and resistances, which are omitted for convenience of explanation in this embodiment, may also be provided as a matter of course.

**Fourth Embodiment**

The fourth embodiment will now be explained. This embodiment will be explained mainly in terms of differences from the above-mentioned third embodiment.

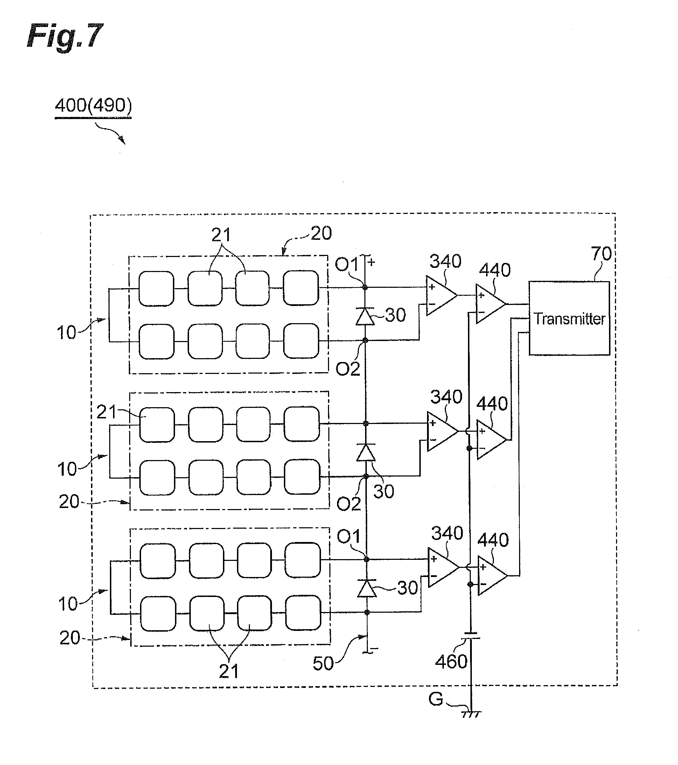

Fig. 7 is a structural diagram illustrating a photovoltaic power generation system including the failure detection device in accordance with the fourth embodiment. As illustrated in Fig. 7, the failure detection device 490 of this embodiment differs from the above-mentioned failure detection device 390 in that the photovoltaic module 300 further comprises comparators 440 while including a reference power supply 460 in place of the reference power supply 360 (see Fig. 6).

Each comparator 440 compares input voltages on the positive and negative electrode sides with each other and outputs the result of the comparison as a binary output voltage. The comparator 440 is disposed on an electric line between the comparator 340 of each photovoltaic unit 10 and the transmitter 70. Specifically, an input terminal on the positive electrode side of each comparator 440 is connected to the output terminal of its corresponding comparator 340, while an input terminal on the negative electrode side of the comparator 440 is connected to the ground (earth potential) G. The output terminal of each comparator 440 is connected to the transmitter 70.

The reference power supply 460 applies a reference potential difference corresponding to the above-mentioned predetermined reverse voltage value (a voltage drop value greater than the voltage drop value Vb) to the input terminal on the negative electrode side of the comparator 440. The reference power supply 460 is disposed on an electric line between the input terminal on the negative electrode side of the comparator 440 and the ground G. The reference power supply 460 allows the comparator 440 to output an output voltage as an OFF signal to the transmitter 70 when the predetermined reverse voltage value is applied to the photovoltaic cluster 20. The comparators 440 of this embodiment are of an insulating type having insulating capability between their input and output sides.

When the predetermined reverse voltage value (a voltage drop value greater than the voltage drop value Vb) is applied to one of the photovoltaic clusters 20 in the plurality of photovoltaic units 10 while the bypass diode 30 is in the open-mode failure in this embodiment, the comparator 340 outputs the output voltage to its corresponding comparator 440, and this comparator 440 outputs the OFF signal to the transmitter 70 (detection step). As a consequence, the open-mode failure of the bypass diode 30 is detected. When the OFF signal is outputted to the transmitter 70, the transmitter 70 transmits a signal to the receiving unit 151 (signal transmission step). As a result, the current of the photovoltaic array 110 is blocked safely.

As in the foregoing, this embodiment also exhibits effects similar to those of the previous embodiments, i.e.,

the effects of easily improving reliability while securing a power generation capacity and of accurately detecting the open-mode failure of the bypass diode 30. As mentioned above, a plurality of photovoltaic units 10 can use one reference power supply 460 in common in this embodiment. Other members concerning the comparators 340, 440 such as general power supplies and resistances, which are omitted for convenience of explanation in this embodiment, may also be provided as a matter of course.

**Fifth Embodiment**

The fifth embodiment will now be explained. This embodiment will be explained mainly in terms of differences from the above-mentioned first embodiment.

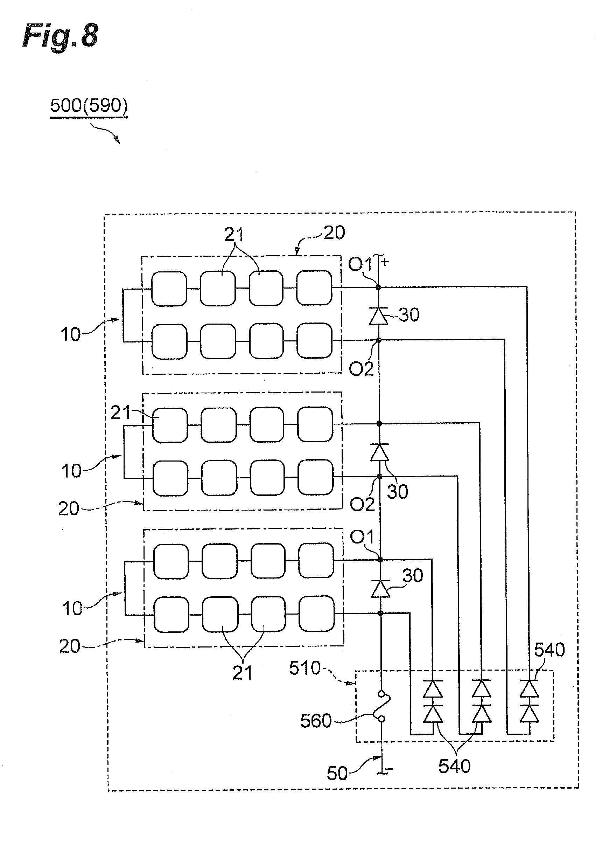

Fig. 8 is a structural diagram illustrating a photovoltaic power generation system including the failure detection device in accordance with the fifth embodiment. This embodiment differs from the above-mentioned first embodiment mainly in that the current is blocked for each photovoltaic module 100 instead of each photovoltaic array 110 as in the above-mentioned first embodiment.

Specifically, as illustrated in Fig. 8, a photovoltaic module 500 in the failure detection device 590 of this embodiment is equipped with heating diodes 540 and a thermal fuse 560 in place of the LED 40, light-receiving element 60 and transmitter 70 (see Fig. 2).

Each heating diode 540 is a reaction element (heating element) connected in parallel with its corresponding photovoltaic cluster 20 and bypass diode 30 and constitutes a detection unit. The forward direction of the heating diode 540 is opposite to the forward direction of equivalent parasitic diodes of the photovoltaic cells 21 in the photovoltaic cluster 20. As with the above-mentioned LED 40, the heating diode 540 is constructed such as to allow a current to flow therethrough and react (heat) when a predetermined reverse voltage value (a voltage drop value greater than the voltage drop value Vb) is applied thereto.

The cathode side of the heating diode 540 is connected to the junction O1 between the positive electrode side of the photovoltaic cluster 20 and the bypass diode 30 on the electric line 50. The anode side of the heating diode 540 is connected to the junction 02 between the negative electrode side of the photovoltaic cluster 20 and the bypass diode 30 on the electric line 50. For example, p-n diodes are used as the heating diodes 540.

The thermal fuse 560 is a blocking element connected in series to a plurality of photovoltaic clusters 20 and a plurality of bypass diodes 30 and constitutes the detection unit and blocking units. The respective heating diodes 540 for the plurality of photovoltaic units 10 are in contact with the thermal fuse 560, so as to be able to transfer their heat directly thereto. That is, the thermal fuse 560 and heating diodes 540 form an element complex 510 in which they are arranged in thermal contact with each other (thermally coupled).

According to the heating of at least one of the plurality of heating diodes 540, the thermal fuse 560 cuts the connection with the plurality of photovoltaic units 10, thereby blocking the current of the plurality of photovoltaic units 10 (photovoltaic modules 100). Only one thermal fuse 560 is disposed on the electric line 50 and connected to the side of the junction O1 of the bypass diode 30 opposite from the photovoltaic cluster 20 with respect to one photovoltaic unit 10.

When a predetermined reverse voltage (a voltage drop value greater than the voltage drop value Vb) is applied to the photovoltaic cluster 20 while the bypass diode 30 is in the open-mode failure in at least one photovoltaic unit 10 in this embodiment, a current flows through the heating diode 540, so as to heat the latter, thereby melting and cutting the thermal fuse 560 (detection and blocking steps). This detects the open-mode failure of the bypass diode 30 and blocks the current of the plurality of photovoltaic units 10 (photovoltaic modules 100).

As in the foregoing, this embodiment also exhibits effects similar to those of the previous embodiments, i.e., the effects of easily improving reliability while securing a power generation capacity and of accurately detecting the open-mode failure of the bypass diode 30. When the bypass diode 30 is in the open-mode failure, this embodiment blocks the current of only a specific photovoltaic module 100 including this bypass diode 30. Therefore, when the bypass diode 30 is in the open-mode failure, the power generation can favorably be continued by the photovoltaic modules 100 other than the specific photovoltaic module 100.

While the thermal fuse 560 serving as a blocking unit is mounted to the photovoltaic module 100 (i.e., provided within the photovoltaic module 100) in this embodiment, a whole or part of the blocking unit may be provided separately from the photovoltaic module 100 (i.e., outside of the photovoltaic module 100).

**Sixth Embodiment**

The sixth embodiment will now be explained. This embodiment will be explained mainly in terms of differences from the above-mentioned fifth embodiment.

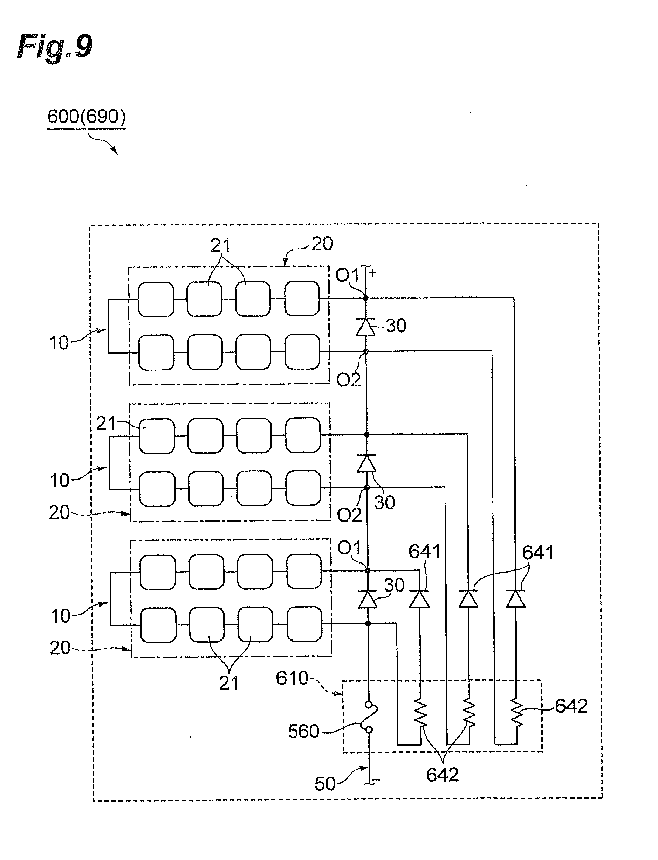

Fig. 9 is a structural diagram illustrating a photovoltaic power generation system including the failure detection device in accordance with the sixth embodiment. As illustrated in Fig. 9, the failure detection device 690 of this embodiment differs from the above-mentioned failure detection device 590 mainly in that a photovoltaic module 600 is equipped with control diodes 641 and resistances 642 as a detection unit in place of the heating diodes 540 (see Fig. 8).

Each control diode 641 controls a current flow and is connected in parallel with its corresponding photovoltaic cluster 20 and bypass diode 30. The forward direction of the control diode 641 is opposite to the forward direction of the photovoltaic cluster 20. As with the above-mentioned heating diode 540, the control diode 641 is constructed such as to allow a current to flow therethrough when a predetermined reverse voltage value (a voltage drop value greater than the voltage drop value Vb) is applied thereto.

The cathode side of the control diode 641 is connected to the junction O1 between the positive electrode side of the photovoltaic cluster 20 and the bypass diode 30 on the electric line 50. The anode side of the control diode 641 is connected to the junction 02 between the negative electrode side of the photovoltaic cluster 20 and the bypass diode 30 on the electric line 50.

As mentioned above, a Schottky barrier diode having a small forward voltage is typically used as the bypass diode 30, while a p-n junction diode having a forward voltage higher than that in the bypass diode 30 can be used as the control diode 641 in this case. When a p-n junction diode is used as the bypass diode 30, on the other hand, a plurality of p-n junction diodes connected in series can be used as the control diode 641. These allow the control diode 641 to exhibit the above-mentioned function easily and favorably.

A plurality of resistances 642 are provided so as to connect in series with the respective control diodes 641 and function as reaction elements (heating elements) which allow a current to flow therethrough and heat. The resistances 642 are in contact with the thermal fuse 560 and can transfer their heat directly thereto. That is, the thermal fuse 560 and resistances 642 form an element complex 610 in which they are arranged in thermal contact with each other (thermally coupled).

When a predetermined reverse voltage (a voltage drop value greater than the voltage drop value Vb) is applied to the photovoltaic cluster 20 while the bypass diode 30 is in the open-mode failure in at least one photovoltaic unit 10 in this embodiment, a current flows through the control diode 641 and resistance 642, so as to heat the latter, thereby melting and cutting the thermal fuse 560 (detection and blocking steps). This detects the open-mode failure of the bypass diode 30 and blocks the current of the plurality of photovoltaic units 10.

This embodiment also exhibits effects similar to those of the previous embodiments, i.e., the effects of easily improving reliability while securing a power generation capacity and of accurately detecting the open-mode failure of the bypass diode 30.

While preferred embodiments are explained in the foregoing, the present invention is not limited thereto but may be modified or applied to others within the scope not changing the gist set forth in each claim.

For example, the number of photovoltaic cells 21 constituting the photovoltaic cluster 20 is not restricted and may be one or more. Similarly, each of the number of photovoltaic clusters 20 constituting the photovoltaic unit 10, the number of photovoltaic units 10 constituting the photovoltaic modules 100, 300, 400, 500, 600, the number of photovoltaic modules 100, 300, 400, 500, 600 constituting the photovoltaic string 130, the number of photovoltaic strings 130 constituting the photovoltaic array 110, and the number of photovoltaic arrays 110 constituting the photovoltaic power generation systems 1, 2 may be one or more.

While the above-mentioned embodiments use the LED 40, light-receiving element 60, comparators 340, 440, heating diodes 540, control diodes 641, and resistances 642 as detection units, they are not restrictive. Other elements such as electromagnetic coils, piezoelectric elements, heating coils, and resistors, for example, may be used as a detection unit, while it is only necessary for the detection unit to be able to detect the open-mode failure of the bypass diode 30.

The open-mode failure of the bypass diode 30 detected by the detection unit may be transmitted to at least one of the blocking unit and display device by utilizing not only communications (the transmitter 70 and receiving unit 151) or heat (thermal coupling) as in the above-mentioned embodiment, but also light (optical coupling) or mechanical means (mechanical coupling).

The above-mentioned embodiments may use elements utilizing thermostats and thermistors in place of the thermal fuse 560. An electromagnetic switch may be opened and closed by a magnetic force of an electromagnetic coil, so as to block a current, or a switch may be opened and closed by utilizing a piezoelectric effect of a piezoelectric element, for example, so as to block a current.

The blocking unit in accordance with one aspect of the present invention may be one which blocks the current of the photovoltaic unit 10 (photovoltaic cluster 20) concerning the bypass diode 30 in the open-mode failure. The signal transmitter in accordance with one aspect of the present invention may transmit a signal when the open-mode failure of the bypass diode 30 is detected in at least one photovoltaic module 100, photovoltaic string 130, or photovoltaic array 110.

The failure detection method of the above-mentioned embodiment can also be regarded as a current blocking method for blocking a current of the photovoltaic power generation system 1 (photovoltaic module 100, photovoltaic unit 10, photovoltaic string 130, or photovoltaic array 110).

The detection unit of the above-mentioned embodiments detects the open-mode failure of the bypass diode 30 when a predetermined reverse voltage value is applied to the photovoltaic cluster 20, but is not limited thereto as long as it can detect the open-mode failure of the bypass diode.

For example, during a period of time when the photovoltaic cluster 20 generates no power, a charged capacitor is connected to each photovoltaic string 130, so as to be discharged, and the voltage and current are measured at a part to be measured during discharging. Then, according to a change in the current-voltage characteristic obtained from the measured voltage and current, electric characteristics of the bypass diode 30 at the part to be measured may be diagnosed, so as to detect the open-mode failure of the bypass diode 30.

**Industrial Applicability**

One aspect of the present invention makes it possible to detect the open-mode failure of the bypass diode.

**Reference Signs List**

1, 2: photovoltaic power generation system; 20: photovoltaic cluster (photovoltaics); 30: bypass diode; 40: LED (detection unit); 60: light-receiving element (detection unit); 70: transmitter (signal transmitter); 90, 390, 490, 590, 690: failure detection device; 100, 300, 400, 500, 600: photovoltaic module; 130: photovoltaic string; 140: switch (blocking unit); 151: receiving unit (signal receiver); 152: switch control unit (blocking unit); 255: display unit (display device); 340: comparator (detection unit); 360: reference power supply (detection unit); 440: comparator (detection unit); 460: reference power supply (detection unit); 540: heating diode (detection unit); 560: thermal fuse (detection unit); 641: control diode (detection unit); 642: resistance (detection unit)

**Claims**

1. A photovoltaic power generation system comprising a photovoltaic module having:

   a photovoltaics for generating power by utilizing solar light;
   a bypass diode connected in parallel with the photovoltaics; and
   a detection unit for detecting an open-mode failure of the bypass diode.

2. A photovoltaic power generation system according to claim 1, wherein the detection unit detects the open-mode failure of the bypass diode when a predetermined reverse voltage value is applied to the photovoltaics; and
   wherein the predetermined reverse voltage value is a voltage drop value greater than that of the photovoltaics occurring when a current having a maximum current value flows through the bypass diode.

3. A photovoltaic power generation system according to claim 2, wherein the maximum current value is a short-circuit current value of the photovoltaics occurring when the whole surface thereof is irradiated with solar light having an amount of solar radiation at a solar constant.

4. A photovoltaic power generation system according to claim 2 or 3, comprising:

   a signal transmitter for transmitting a signal including a failure signal when the detection unit detects the open-mode failure of the bypass diode;
   a signal receiver for receiving the signal from the signal transmitter; and
   a display device for displaying information concerning the open-mode failure of the bypass diode in response to the reception of the signal by the signal receiver.

5. A photovoltaic power generation system according to claim 4, wherein the signal transmitter transmits the signal further including a characteristic value signal for identifying the photovoltaic module having the bypass diode in the open-mode failure.

6. A photovoltaic power generation system according to claim 4 or 5, comprising:

   at least one photovoltaic string constituted by a plurality of such photovoltaic modules connected in series;
   a signal transmitter for transmitting a signal including a failure signal when the detection unit detects the open-mode failure of the bypass diode for at least one of the plurality of photovoltaic modules;
   a signal receiver for receiving the signal from the signal transmitter; and

a display device for displaying information concerning the open-mode failure of the bypass diode in response to the reception of the signal by the signal receiver.

7. A photovoltaic power generation system according to claim 6, wherein the signal transmitter transmits the signal further including a characteristic value signal for identifying the photovoltaic module having the bypass diode in the open-mode failure; and
wherein the display device displays the information including specific information specifying the photovoltaic module corresponding to the specific value signal of the signal when the signal receiver receives the signal.

8. A photovoltaic power generation system according to claim 1, comprising a blocking unit for blocking a current of the photovoltaics when the detection unit detects the open-mode failure of the bypass diode.

9. A photovoltaic power generation system according to claim 8, wherein the detection unit detects the open-mode failure of the bypass diode when a predetermined reverse voltage value is applied to the photovoltaics; and
wherein the predetermined reverse voltage value is a voltage drop value greater than that of the photovoltaics occurring when a current having a maximum current value flows through the bypass diode.

10. A photovoltaic power generation system according to claim 9, wherein the maximum current value is a short-circuit current value of the photovoltaics occurring when the whole surface thereof is irradiated with solar light having an amount of solar radiation at a solar constant.

11. A photovoltaic power generation system according to one of claims 8 to 10, comprising:

a signal transmitter for transmitting a signal including a failure signal when the detection unit detects the open-mode failure of the bypass diode; and
a signal receiver for receiving the signal from the signal transmitter;
wherein the blocking unit blocks the current of the photovoltaics in response to the reception of the signal by the signal receiver.

12. A photovoltaic power generation system according to claim 11, wherein the signal transmitter transmits the signal further including a characteristic value signal for identifying the photovoltaic module having the bypass diode in the open-mode failure.

13. A photovoltaic power generation system according to claim 11 or 12, comprising a display device for displaying information concerning the open-mode failure of the bypass diode in response to the reception of the signal by the signal receiver.

14. A photovoltaic power generation system according to claim 11, comprising at least one photovoltaic string constituted by a plurality of such photovoltaic modules connected in series;
wherein the signal transmitter transmits the signal further including a specific value signal for identifying the photovoltaic module having the bypass diode in the open-mode failure; and
wherein the blocking unit blocks the current of the photovoltaic string including the photovoltaic module corresponding to the specific value signal of the signal when the signal receiver receives the signal.

15. A photovoltaic power generation system according to claim 11, comprising:

at least one photovoltaic string constituted by a plurality of such photovoltaic modules connected in series; and
a display device for displaying information concerning the open-mode failure of the bypass diode in response to the reception of the signal by the signal receiver;
wherein the signal transmitter transmits the signal further including a specific value signal for identifying the photovoltaic module having the bypass diode in the open-mode failure;
wherein the blocking unit blocks the current of the photovoltaic string including the photovoltaic module corresponding to the specific value signal of the signal when the signal receiver receives the signal; and
wherein the display device displays the information including specific information specifying the photovoltaic module corresponding to the specific value signal of the signal when the signal receiver receives the signal.

16. A failure detection method comprising a detection step of detecting an open-mode failure of a bypass diode connected in parallel with a photovoltaics for generating power by utilizing solar light;

wherein the detection step detects the open-mode failure of the bypass diode when a predetermined reverse voltage value is applied to the photovoltaics; and

wherein the predetermined reverse voltage value is a voltage drop value greater than that of the photovoltaics occurring when a current having a maximum current value flows through the bypass diode.

17. A failure detection method according to claim 16, wherein the maximum current value is a short-circuit current value of the photovoltaics occurring when the whole surface thereof is irradiated with solar light having an amount of solar radiation at a solar constant.

18. A failure detection method according to claim 16 or 17, comprising:

a signal transmission step of transmitting a signal including a failure signal when the open-mode failure of the bypass diode is detected by the detection step;

a signal reception step of receiving the signal transmitted by the signal transmission step; and

a display step of displaying information concerning the open-mode failure of the bypass diode in response to the reception of the signal by the signal reception step.

19. A failure detection method according to claim 18, wherein the signal transmission step transmits the signal further including a characteristic value signal for identifying the photovoltaic module having the bypass diode in the open-mode failure.

**Fig.1**

# Fig.2

*Fig.3*

(a)

IV Curve of
Bypass Diode

IV Curve of
Heating Diode

Current

Voltage

IV Curve of
Photovoltaic cluster

(b)

IV Curve L1 of
Photovoltaic unit
(Normal)

Max Current Value

IV Curve L2 of
Photovoltaic unit
(upon Open-Mode Failure
of Bypass Diode)

Current

H

Vb

Voltage

# *Fig.4*

(a)

21b(21)   21a(21)                    21a(21)

Power
Consumption
(Voltage Drop)

Power Generation

(b)

Current

L3

P2                                    P1

Voltage

L4

*Fig5*

2(90)

# Fig.6

# Fig.7

## Fig.8

## Fig.9

600(690)

### INTERNATIONAL SEARCH REPORT

| International application No. |
|---|
| PCT/JP2013/052020 |

**A. CLASSIFICATION OF SUBJECT MATTER**
*H01L31/042*(2006.01)i, *H01L31/04*(2006.01)i

According to International Patent Classification (IPC) or to both national classification and IPC

**B. FIELDS SEARCHED**

Minimum documentation searched (classification system followed by classification symbols)
H01L31/04-31/078

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2011-066320 A (Tokyo University of Science),<br>31 March 2011 (31.03.2011),<br>entire text; all drawings<br>(Family: none) | 1-3,16-17<br>4-15,18-19 |
| A | JP 2001-024204 A (Canon Inc.),<br>26 January 2001 (26.01.2001),<br>entire text; all drawings<br>(Family: none) | 1-19 |
| Y | WO 2010/052984 A1 (Sharp Corp.),<br>14 May 2010 (14.05.2010),<br>paragraphs [0040] to [0041]<br>(Family: none) | 4-7,11-15,<br>18-19 |

☒ Further documents are listed in the continuation of Box C.　　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 February, 2013 (15.02.13) | 26 February, 2013 (26.02.13) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2013/052020

C (Continuation).  DOCUMENTS CONSIDERED TO BE RELEVANT

| Category* | Citation of document, with indication, where appropriate, of the relevant passages | Relevant to claim No. |
|---|---|---|
| Y | WO 2010/113767 A1  (Sharp Corp.),<br>07 October 2010 (07.10.2010),<br>paragraph [0029]<br>& EP 2415938 A1          & KR 10-2012-0011863 A<br>& CN 102428235 A | 8-15 |
| P,X | WO 2012/102028 A1  (Hitachi, Ltd.),<br>02 August 2012 (02.08.2012),<br>paragraphs [0046] to [0071]; fig. 6 to 7<br>(Family: none) | 1-19 |

Form PCT/ISA/210 (continuation of second sheet) (July 2009)

| INTERNATIONAL SEARCH REPORT | International application No. |
|---|---|
| | PCT/JP2013/052020 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
```
    The invention of claim 1 does not have novelty in the light of the document
(JP 2011-066320 A) which is cited in this international search report.
    Therefore, any common special technical feature cannot be found between
(1) the inventions of claims 1-8 and 16-19 and (2) the inventions of claims
9-15.
```

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**EP 2 811 536 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001024204 A